# EUROPÄISCHE PATENTANMELDUNG

(11) **EP 2 423 959 A2**
(43) Veröffentlichungstag der Anmeldung: **29.02.2012**
(21) Anmeldenummer: 11176833.9
(22) Anmeldetag: 08.08.2011
(51) Int. Cl.: H01L 25/11, H01L 23/485

(54) **Leistungsbaugruppe mit einer flexiblen Verbindungseinrichtung**

(30) Priorität: 26.08.2010 DE 102010039824
(71) Anmelder: Semikron Elektronik GmbH & Co. KG Patentabteilung, 90431 Nürnberg (DE)
(72) Erfinder: Dr. Stockmeier, Thomas, 90471 Nürnberg (DE)

(57) **Zusammenfassung**

Die Anmeldung betrifft eine Leistungsbaugruppe mit einem Substrat, mindestens einem ersten und einem zweiten Leistungshalbleiterbauelemente und einer Verbindungseinrichtung, wobei das Substrat Leiterbahnen zur Anordnung der Leistungshalbleiterbauelemente aufweist. Die Leistungshalbleiterbauelemente weisen erste Kontaktfläche auf, während die Verbindungseinrichtung aus einer Schichtfolge elektrisch leitender Folien und elektrisch isolierender Folien, die in sich strukturiert sind um Teilfolien auszubilden. Eine erste Teilfolie der ersten leitenden Folie weist eine erste Kontaktfläche auf, die mit einer zugeordneten ersten Kontaktfläche der ersten Hauptfläche des Leistungshalbleiterbauelements unmittelbar mechanisch verbunden ist. Weiterhin ist die Teilfolie mit einer zweiten Teilfolie einer zweiten leitenden Folie mittels einer Durchkontaktierung durch die dazwischen angeordnete isolierende Folie elektrisch leitend verbunden ist. Ebenso ist eine erste Kontaktfläche eines zweiten Leistungshalbleiterbauelements mit dieser zweiten Teilfolie verbunden, und / oder ist eine zweite Kontaktfläche einer zweiten von der ersten elektrisch isolierten Leiterbahn des Substrats mechanisch mittelbar oder unmittelbar mit der zweiten Teilfolie und hierüber mit der ersten Kontaktfläche des ersten Leistungshalbleiterbauelements elektrisch leitend verbunden.

## Beschreibung

Die Erfindung beschreibt eine Leistungsbaugruppe, wie sie aus Leistungshalbleitermodulen bekannt ist und dort die funktionale Einheit, wie beispielhaft eine Halbbrückenschaltung, bildet. Derartige Leistungsbaugruppen werden gebildet aus einem Substrat mit Leistungshalbleiterbauelementen und den notwendigen Verbindungselementen. Grundsätzlich sind diese Verbindungselemente bekannt als Drahtbondverbindungen.

Als zumindest teilweiser, vorzugsweise aber vollständiger Ersatz dieser Drahtbondverbindungen sind beispielhaft aus der DE10 2007 006 706 A1 mechanisch flexible Verbindungseinrichtungen bekannt, die aus einem Folienverbund von leitenden und isolierenden Folien bestehen. Hierbei ist es bevorzugt, wenn die leitenden Folien in sich strukturiert sind und somit Teilfolien ausbilden, wodurch die notwendige Flexibilität für die zu realisierende Verbindungstopologie realisiert wird. Nachteilig an derartigen Ausgestaltungen ist allerdings, dass, wie beispielhaft in der DE 10 2007 044 620 A1, offenbart partiell zwischen der Verbindungseinrichtung und dem Substrat ein elektrisch isolierender Füllstoff notwendig ist.

Der Erfindung liegt die Aufgabe zugrunde die bekannte Leistungsbaugruppe vorzustellen, bei der die Verbindungseinrichtung dahingehend weitergebildet wurde, dass auf das partielle Vorsehen, speziell im Randbereich eines Leistungshalbleiterbauelements, eines elektrisch isolierenden Füllstoff zwischen der Verbindungseinrichtung und dem Substrat verzichtet werden kann.

Die Aufgabe wird erfindungsgemäß gelöst durch eine Leistungsbaugruppe gemäß dem Anspruch 1. Bevorzugte Ausführungsformen sind in den abhängigen Ansprüchen beschrieben.

Ausgangspunkt der Erfindung ist ein Leistungshalbleitermodul, das aus einem Gehäuse externen Anschlusselementen und mindestens einer funktionalen Leistungsbaugruppe besteht. Diese Leistungsbaugruppe weist ein Substrat, mindestens ein erstes und ein zweites Leistungshalbleiterbauelement und mindestens eine mechanisch flexible Verbindungseinrichtung auf. Das Substrat weist seinerseits eine erste Hauptfläche mit einer Mehrzahl von elektrisch voneinander isolierten ersten und zweiten Leiterbahnen zur schaltungsgerechten Anordnung der Leistungshalbleiterbauelemente auf. Diese Leistungshalbleiterbauelemente sind vorzugsweise mit zweiten Kontaktflächen auf der dem Substrat zugewandten Hauptfläche elektrisch leitend und mechanisch mit zugeordneten Leiterbahnen an dortigen ersten Kontaktflächen verbunden. Auf der dem Substrat abgewandten Hauptfläche des jeweiligen Leistungshalbleiterbauelements ist jeweils mindestens eine erste Kontaktfläche angeordnet.

Die flexible Verbindungseinrichtung der Leistungsbaugruppe besteht aus einer alternierenden Schichtfolge elektrisch leitender Folien und mindestens einer elektrisch isolierender Folie, wodurch sich grundsätzlich ein Stapel aus mindestens drei Folien ergibt. Mindestens eine der leitende Folie ist in sich strukturiert ist um Teilfolien auszubilden, wodurch sich von dieser Folie frei gesparte Bereiche in dem Stapel ergeben.

Erfindungsgemäß weißt eine erste leitende Folie mindestens eine erste Teilfolie mit einer zugeordneten ersten Kontaktfläche auf, die mechanisch unmittelbar und elektrisch leitend mit einer zugeordneten ersten Kontaktfläche auf der ersten Hauptfläche eines zugeordneten Leistungshalbleiterbauelements verbunden ist. Hierbei ist diese erste Teilfolie einer ersten leitenden Folie mit einer zweiten Teilfolie einer zweiten leitenden Folie mittels mindestens einer ersten Durchkontaktierung durch die dazwischen angeordnete isolierende Folie elektrisch leitend verbunden.

Diese erste Durchkontaktierung ist vorzugsweise in demjenigen ersten Abschnitt der isolierenden Folie angeordnet, der benachbart der ersten Hauptfläche des Leistungshalbleiterbauelements ist, wodurch sich gewissermaßen eine vertikale Schichtfolge aus Kontaktfläche des Leistungshalbleiterbauelements, Kontaktfläche der ersten Teilfolie, dieser selbst, der Durchkontaktierung und einem Teil der zweiten Teilfolie ergibt.

Es ist weiterhin bevorzugt, wenn dieser erste Abschnitt der isolierenden Folie in seiner horizontalen Ausdehnung das jeweilige Leistungshalbleiterbauelement allseitig ausreichend weit überlappt und somit elektrisch gegen die zweite Folie, bzw. mindestens eine zweite Teilfolie, isoliert.

Demgegenüber ist es bevorzugt, wenn die die erste Teilfolie einer ersten leitenden Folie horizontal bis maximal an den Rand des zugeordneten Leistungshalbleiterbauelements ausgedehnt ist und somit das Leistungshalbleiterbauelement horizontal nicht überlappt. In diesem Fall dient diese erste Teilfolie nur als Verbindungshilfsmittel zur zweiten leitenden Folie, die dann ihrerseits die weitere interne, oder auch externe, elektrisch leitende Verbindung des Leistungshalbleiterbauelements bildet. Bei dieser Ausgestaltung ist es weiterhin sinnvoll die erste leitende Folie möglichst dünn auszugestalten, da ihre Stromtragfähigkeit im Querschnitt im Gegensatz zur zweiten leitenden Folie gering ausfallen kann.

Weiterhin ist eine erste Kontaktfläche eines zweiten Leistungshalbleiterbauelements ebenso mittels einer ersten Teilfolie und einer ersten Durchkontaktierung mit der zweiten Teilfolie und somit mit der ersten Kontaktfläche des ersten Leistungshalbleiterbauelements elektrisch leitend verbunden, wodurch eine elektrisch leitende Verbindung der ersten Hauptflächen, bzw. der dort angeordneten Kontaktflächen, zweier Leistungshalbleiterbauelement mittels der zweiten Teilfolie entsteht.

Alternativ oder ergänzend hierzu ist eine zweite Kontaktfläche einer zweiten von der ersten elektrisch isolierten Leiterbahn des Substrats mittelbar oder unmittelbar mit der zweiten Teilfolie mechanisch verbunden, wodurch sich eine elektrisch leitende Verbindung dieser zweiten Kontaktfläche zum Leistungshalbleiterbauelement, bzw. dessen erster Kontaktfläche, ergibt. Die unmittelbare mechanische Verbindung wird hierbei vorzugsweise ausgebildet durch eine stoff- oder kraftschlüssige Verbindung der zweiten Kontaktfläche der zweiten Leiterbahn des Substrats mit einer Kontaktfläche der zweiten Teilfolie der zweiten leitenden Folie.

Die alternative mittelbare mechanische Verbindung wird hierbei vorzugsweise ausgebildet durch eine stoff- oder kraftschlüssige Verbindung einer dritten Teilfolie (400c) der ersten leitenden Folie, die mittels einer zweiten Durchkontaktierung durch die isolierende Folie mit der zweiten leitenden Folie verbunden ist.

Unter einer unmittelbaren mechanischen Verbindung wird folglich eine Verbindung zweier Verbindungspartner verstanden, die maximal nur durch das Verbindungsmittel, wie beispielhaft einen adhäsiven Stoff, voneinander beabstandet sind. Demgegenüber weist eine mittelbare mechanische Verbindung weitere zwischen den Verbindungspartnern angeordnete Komponenten auf.

Die erfinderische Lösung wird an Hand der Ausführungsbeispiele gemäß den Fig. 1 bis 4 weiter erläutert.

Fig. 1 zeigt das Schaltbild einer Halbbrückenschaltungsanordnung.

Fig. 2 zeigt eine erste Ausgestaltung einer erfindungsgemäßen Leistungsbaugruppe in Schnittansicht.

Fig. 3 zeigt diese Leistungsbaugruppe in Draufsicht.

Fig. 4 zeigt eine zweite Ausgestaltung einer erfindungsgemäßen Leistungsbaugruppe in Schnittansicht.

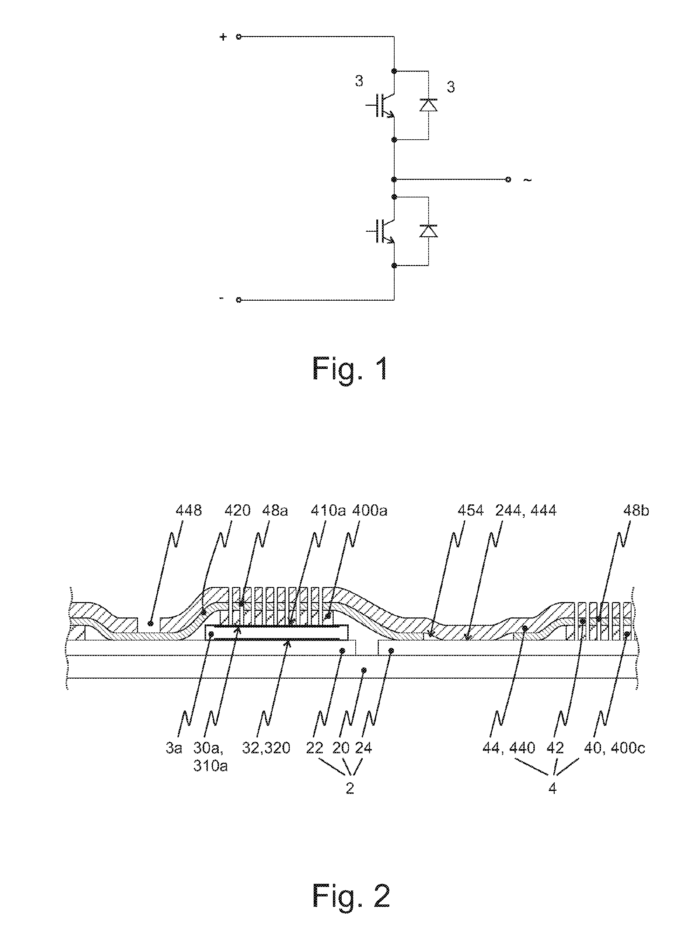

Fig. 1 zeigt das Schaltbild einer Halbbrückenschaltungsanordnung. Diese Halbbrückenschaltung besteht aus einem ersten und einem zweiten Leistungsschalter in Reihenschaltung mit einem Gleichspannungseingang dieser Reihenschaltung und einem Wechselspannungsausgang an deren Mittenanzapfung. Typischerweise ist jeder dieser Leistungsschalter ausgebildet durch eine Mehrzahl von Leistungstransistoren mit antiparallel geschalteten Leistungsdioden als Leistungshalbleiterbauelemente (3).

Diese Halbbrückenschaltungsanordnung bildet einen bedeutenden Grundtyp leistungselektronischer Schaltungen, realisiert in einer Vielzahl verschiedener Leistungshalbleitermodule. Eine erfindungsgemäße Leistungsbaugruppe umfasst beispielhaft genau eine derartige Halbbrückenschaltungsanordnung als eine funktionale Einheit eines Leistungshalbleitermoduls. Selbstverständlich ist die erfindungsgemäße Leistungsbaugruppe nicht auf diese Topologie beschränkt.

Fig. 2 zeigt eine erste Ausgestaltung einer erfindungsgemäßen Leistungsbaugruppe in Schnittansicht. Dargestellt ist ein Substrat (2) mit einer ersten (22) und einer zweiten (24) elektrisch voneinander isolierten Leiterbahn. In dieser Ausgestaltung weist das Substrat (2) zur Ausbildung dieser isolierenden Funktion einen Grundkörper (20) aus einem Isolierstoff, beispielhaft einer Isolierkeramik, auf. Dargestellt ist weiterhin ein Leistungshalbleiterbauelement (3a), hier eine Leistungsdiode mit zwei Hauptflächen (30a, 32) und auf diesen Hauptflächen angeordnete Kontaktflächen (310a, 320). Die zweite Kontaktfläche (320) ist hier mit der ersten Leiterbahn (22) des Substrats (2) elektrisch leitend und mechanisch fixierend verbunden.

Zur elektrisch leitenden Verbindung der ersten Kontaktfläche (310a) angeordnet auf der ersten dem Substrat (2) abgewandten Seite des Leistungshalbleiterbauelements (3) mit der zweiten Leiterbahn (24) ist eine Verbindungseinrichtung (4) vorgesehen. Diese Verbindungseinrichtung (4) ist hier ein Folienverbund mit einer ersten (40) und einer zweiten (44) leitenden Folie und eine dazwischen angeordneten isolierenden Folie (42). Bevorzugt ist es um eine mechanisch Flexibilität dieses Folienverbunds (4) zu erhalten, dass die leitenden Folien (40, 44) eine Dicke zwischen 50µm und 500µm und die isolierende Folie (42) eine Dicke zwischen 10µm und 100µm aufweisen.

Weiterhin sind hier beide leitenden Folien (40, 44) dieses Folienverbundes (4) in sich strukturiert um einzelne den Folien zugeordnete Teilfolien (400a, 440) als deren Teile auszubilden. Ebenso kann die Isolierende Folie (42) strukturiert sein. Somit ist der Verband (4) aus drei Folien nur abschnittsweis vollständig ausgebildet. Beispielhaft bildet die erste dem Substrat (2) zugewandte leitende Folie (40) eine erste Teilfolie (400a) oberhalb, also direkt benachbart zur, ersten Hauptfläche (30a) und nur auf den Bereich der dortigen ersten Kontaktfläche (310a) des Leistungshalbleiterbauelements (3) beschränkt aus. Als Verbindungstechnik für die elektrisch leitende Verbindung eigenen sich beispielhaft alle bekannten stoffschlüssigen Verbindungen, insbesondere auch Sinterverbindungen. Grundsätzlich ebenso anwendbar sind kraftschlüssige Verbindungen

In diesem Bereich ist auch eine erste Durchkontaktierung (48a) bestehend aus mehreren Ausnehmungen des Folienverbunds (4) vorgesehen um die erste Teilfolie (400a) der ersten leitenden Folie (40) mit einer zweiten Teilfolie (440) der zweiten leitenden Folie (44) elektrisch leitend zu verbinden.

Diese zweite Teilfolie (440) ist direkt über eine eigene zugeordnet Kontaktfläche (444) mit einer Kontaktfläche (244) der zweiten Leiterbahn (24) elektrisch leitend und unmittelbar mechanisch verbunden. Zur Ausbildung dieser Verbindung eignen sich ebenfalls stoff- oder kraftschlüssige Verbindungstechniken.

Als Alternative zur unmittelbaren mechanischen Verbindung ist weiterhin die mittelbare mechanische Verbindung der zweiten Teilfolie (440) mit der zweiten Leiterbahn (24) des Substrats (2) dargestellt. Hierzu weist die Verbindungseinrichtung (4) eine dritte Teilfolie (400c) der ersten leitenden Folie (40) auf, die mittels einer zweiten Durchkontaktierung (48b), die vorzugsweise identisch zur ersten ausgebildet ist auf. Diese dritte Teilfolie (400c) ist nicht nur aus Gründen der ökomischen Herstellung vorzugsweise in gleicher Verbindungstechnologie mit der zweiten Leiterbahn (24) bzw. deren Kontaktfläche (244) verbunden, wie die erste Teilfolie (400a) mit der Kontaktfläche (310a) des Leistungshalbleiterbauelements (3) verbunden ist.

Grundsätzlich ist es innerhalb einer Leistungsbaugruppe möglich sowohl unmittelbare wie auch mittelbare mechanische Verbindungen der zweiten Teilfolie (440) mit der zweiten Leiterbahn (24) vorzusehen, dies kann abhängig vom Platzbedarf und der umgebenden Komponenten beliebig ausgewählt werden. Beispielhaft kann bei sehr geringen Abständen des Leistungshalbleiterbauelements (3) von der Kontaktstelle mit der zweiten Leiterbahn die mittelbare Verbindung bevorzugt sein, wenn die zweite leitende Folie (44) wegen hoher Stromtragfähigkeit besonders dick gewählt werden muss, weil dadurch die mechanische Flexibilität der Verbindungseinrichtung (4) geringer ist. Ebenso beeinflusst die Art und Anzahl der sonstigen durch die Verbindungseinrichtung (4) zu führender Potentiale diese Auswahl im speziellen Anwendungsfall.

Die zwischen den beiden leitenden Folien (40, 44) angeordnete isolierende Folie (42) ist hierzu im Bereich der unmittelbaren Verbindung der zweiten Teilfolie (440) mit der zweiten Kontaktfläche (244) der zweiten Leiterbahn (24) freigespart. Im Bereich der Verbindung der ersten Hauptfläche (310a) des Leistungshalbleiterbauelements (3) mit der zweiten Leiterbahn (24) überlappt somit die isolierende Folie (42) das Leistungshalbleiterbauelement (3) über dessen Randbereich bis hin zum Rand (454) der Verbindung der zweiten Leiterbahn (244) mit der zweiten Teilfolie (440). Es ist bevorzugt, wenn diese Überlappung des Leistungshalbleiterbauelements (3) durch die isolierenden Folie (42) über den Randbereich allseitig erfolgt.

Der wesentliche Vorteil dieser Ausgestaltung liegt darin begründet, dass hier die isolierende Folie (42) als elektrische Isolation der zweiten Teilfolie (440) zur ersten Leiterbahn (22) hin wirkt und somit auf den Einsatz zusätzlicher Mittel zur Ausbildung dieser Isolation verzichtet werden kann.

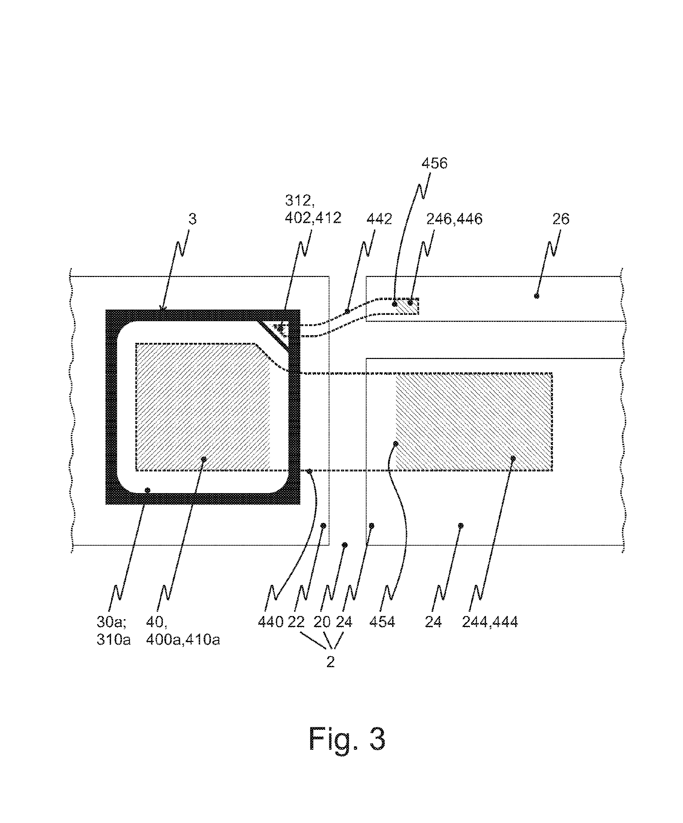

Fig. 3 zeigt diese eben beschrieben Leistungsbaugruppe in Draufsicht mit dem Unterschied, dass hier als Leistungshalbleiterbauelement (3a) ein Leistungstransistor vorgesehen ist. Dieser Leistungstransistor (3a) weist auf seiner ersten Hauptfläche (30a) zwei erste Kontaktflächen (310a, 312) auf, wovon die größere (310a) dem Lastanschluss und die kleinere (312) dem Steueranschluss dient. Dargestellt ist das Substrat (2) mit drei Leiterbahnen (22, 24, 26), wobei die erste (22) und eine zweite (24) zur Laststromführung und eine weitere zweite (26) Leiterbahn zur Führung eines Steuerstroms dient.

Die zweiten Leiterbahnen (24, 26) weisen jeweils Kontaktflächen (244, 246) zur unmittelbaren mechanischen und auch elektrisch leitenden Verbindung mit jeweils zweiten, allerdings voneinander elektrisch isolierten Teilfolien (440, 442) der zweiten leitenden Folie (44) auf. Eine zweite Teilfolie (440) verbindet wie auch in Fig. 2 dargestellt eine Lastkontaktfläche (31 0a) des Leistungshalbleiterbauelements (3) mit einer zweiten Leiterbahn (24), während die andere zweite Teilfolie (442) die Steuerkontaktfläche (312) des Leistungshalbleiterbauelements (3) mit der weiteren zweiten Leiterbahn (26) verbindet.

Die in Draufsicht laterale Ausdehnung, die der horizontalen Ausdehnung gemäß Ansicht in Fig. 2 entspricht, der jeweils ersten Teilfolie (400a) und damit ihrer zugeordneten Kontaktfläche (41 0a) der ersten Leitenden Folie (40) ist hier jeweils kleiner als die laterale Ausdehnung der zugeordneten Kontaktflächen (310a) des Leistungshalbleiterbauelements.

Die in Draufsicht laterale Ausdehnung, die der horizontalen Ausdehnung gemäß Ansicht in Fig. 2 entspricht, der hier nicht dargestellten isolierenden Folie, reicht bei eine derartigen Ausgestaltung allerdings allseitig über das Leistungshalbleiterbauelement (3) bis an den jeweiligen Rand (454, 456) der Kontaktflächen (244, 444, 246, 446) zwischen zweiten Leiterbahnen (24, 26) und zweiten Teilfolien (440, 442).

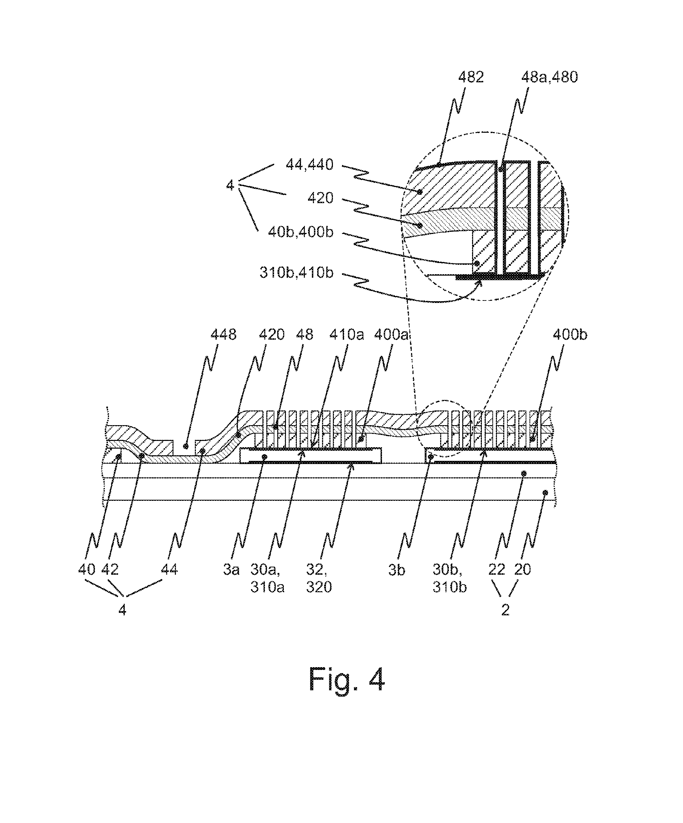

Fig. 4 zeigt eine zweite Ausgestaltung einer erfindungsgemäßen Leistungsbaugruppe in Schnittansicht. Dargestellt ist hier die elektrisch leitende Verbindung zweier gleicher parallel geschalteter Leistungshalbleiterbauelemente (3 a/b), wie es in der technischen Realisierung von Halbbrückenschaltungen häufig notwendig ist. In gleicher Weise eine Antiparallelschaltung eines Leistungstransistors und einer Leistungsdiode ausgebildet sein.

Auf einer gemeinsamen ersten Leiterbahn (22) eines Substrats (2), das grundsätzlich gleich demjenigen gemäß Fig. 2 ausgebildet ist sind hier die beiden Leistungshalbleiterbauelemente (3 a/b) mit ihren zweiten Kontaktflächen (320) angeordnet und elektrisch leitend verbunden. Die ersten Kontaktflächen (310 a/b) auf den ersten Hauptflächen (30 a/b) sind jeweils mit ersten Teilfolien (400 a/b) der ersten leitenden Folie (40) verbunden, wobei erfindungsgemäß diese erste leitende Folie (40) nicht die elektrisch leitende Verbindung zwischen den jeweiligen Leistungshalbleiterbauelementen (3 a/b) ausbildet. Zur Ausbildung dieser Verbindung ist es daher ausreichend wenn die horizontale Ausdehnung der ersten Teilfolien (400 a/b) geringer ist als die horizontale Ausdehnung des Leistungshalbleiterbauelements (3 a/b). Es ist darüber hinaus sogar bevorzugt, wenn die horizontale Ausdehnung der ersten Teilfolien (400 a/b) geringer ist als die horizontale Ausdehnung der zugeordneten Kontaktflächen (310 a/b) des jeweiligen Leistungshalbleiterbauelements (3 a/b).

Zur Verbindung der beiden Leistungshalbleiterbauelemente (3 a/b) ist jede der ersten Teilfolien (400 a/b) mittels erster Durchkontaktierungen (48a) mit einer gemeinsamen zweiten Teilfolie (440) der zweiten leitenden Folie (44) elektrisch leitend verbunden, wodurch diese zweite Teilfolie (440) auch die elektrisch leitende Verbindung zwischen den Leistungshalbleiterbauelementen (3a/b) ausbildet.

Auch in dieser Ausgestaltung kann die erste leitende Folie (40) besonders dünn im Vergleich zur zweiten leitenden Folie (44) ausgestaltet werden, da die erste leitende Folie (40) im Querschnitt keine hohe Stromtragfähigkeit aufweisen muss. Da typischerweise auch die isolierende Folie (42) bei geeigneter Wahl sehr dünn ausgebildet sein kann und somit nur die zweite leitende Folie (44) signifikant ist, weist die gesamte Verbindungseinrichtung (4) eine hohe mechanische Flexibilität auf. Diese ist hier gepaart mit dem bereits genannten Vorteil auf zusätzlich Isolationsmittel im Inneren der Leistungsbaugruppe verzichten zu können.

Im Detail ist weiterhin die Ausbildung der ersten Durchkontaktierung (48a) dargestellt, wobei vorteilhafterweise die zweite Durchkontaktierung (48b) gemäß Fig. 2 in ebensolcher Weise ausgebildet ist. Die Durchkontaktierung (48a) besteht aus einer Mehrzahl, vorzugsweise einer Vielzahl von runden Ausnehmungen (480) fluchtend durch alle Folien (40, 42, 44) der Verbindungseinrichtung (4). Diese Ausnehmungen (480) und die gesamte frei liegende Oberfläche der leitenden Folien (40, 44) sind von eine idealerweise einheitlich dicken Metallisierung (482) überzogen. Die Dicke dieser Metallisierung (482) liegt vorteilhafterweise in der Größenordnung von 1µm.

## Patentansprüche

1. Leistungsbaugruppe (1) mit einem Substrat (2), mindestens einem ersten und einem zweiten Leistungshalbleiterbauelement (3 a/b) und mindestens einer mechanisch flexiblen Verbindungseinrichtung (4),
wobei das Substrat (2) eine erste Hauptfläche mit einer Mehrzahl von voneinander isolierten Leiterbahnen (22, 24, 26) zur schaltungsgerechten Anordnung der Leistungshalbleiterbauelemente (3 a/b) aufweist
wobei die jeweils erste, dem Substrat abgewandten Hauptfläche (30) des jeweiligen Leistungshalbleiterbauelements (3 a/b) jeweils mindestens eine erste Kontaktfläche (310 a/b, 312) aufweist,
die flexible Verbindungseinrichtung (4) aus einer alternierenden Schichtfolge elektrisch leitender Folien (40, 44) und mindestens einer elektrisch isolierender Folie (42) besteht und hierbei mindestens eine leitende Folie (40, 44) in sich strukturiert ist um Teilfolien (400 a/b/c, 402, 440, 442) auszubilden,
wobei eine erste leitende Folie (40) mindestens eine erste Teilfolie (400 a/b/c, 402) mit einer ersten Kontaktfläche (410 a/b, 412) aufweist und diese elektrisch leitend und unmittelbar mechanisch mit einer zugeordneten ersten Kontaktfläche (310 a/b, 312) der ersten Hauptfläche (30 a/b) des jeweiligen Leistungshalbleiterbauelements (3) verbunden ist, wobei
mindestens eine dieser ersten Teilfolien (400 a/b, 402) der ersten leitenden Folie (40) mit einer zweiten Teilfolie (440) einer zweiten leitenden Folie (44) mittels mindestens einer ersten Durchkontaktierung (48a) durch die dazwischen angeordnete isolierende Folie (42) elektrisch leitend verbunden ist und
eine erste Kontaktfläche (31 0b) eines zweiten Leistungshalbleiterbauelements (3b) ebenso mit dieser zweiten Teilfolie (440) und hierüber mit der ersten Kontaktfläche (310a) des ersten Leistungshalbleiterbauelement (3a) elektrisch leitende verbunden ist, und / oder
eine zweite Kontaktfläche (244, 246) einer zweiten (24, 26) von der ersten (22) elektrisch isolierten Leiterbahn des Substrats (2) mechanisch mittelbar oder unmittelbar mit der zweiten Teilfolie und hierüber mit der ersten Kontaktfläche (310a) des ersten Leistungshalbleiterbauelements (3a) elektrisch leitend verbunden ist.

2. Leistungsbaugruppe nach Anspruch 1, wobei
die unmittelbare mechanische Verbindung einer Kontaktfläche (410 a/b, 412) einer ersten Teilfolie (400 a/b, 402) der ersten Folie (40) mit der ersten Kontaktfläche (310 a/b, 312) des jeweiligen Leistungshalbleiterbauelements (3 a/b) als stoff- oder kraftschlüssige Verbindung ausgebildet ist.

3. Leistungsbaugruppe nach Anspruch 1, wobei
die unmittelbare mechanische Verbindung einer Kontaktfläche (444, 446) einer zweiten Teilfolie (440, 442) mit einer Kontaktfläche (244, 246) einer zweiten Leiterbahn (24, 26) des Substrats (2) als stoff- oder kraftschlüssige Verbindung ausgebildet ist.

4. Leistungsbaugruppe nach Anspruch 1, wobei
die mittelbare mechanische Verbindung einer zweiten Teilfolie (440, 442) mit einer Kontaktfläche (244, 246) einer zweiten Leiterbahn (24, 26) des Substrats (2) mittels einer zweiten Durchkontaktierung (48b) durch die isolierende Folie (42) zu einer stoff-oder kraftschlüssige mit der Kontaktfläche (244, 246) der zweiten Leiterbahn (24, 26) verbundenen dritten Teilfolie (400c) der ersten leitenden Folie (40) ausgebildet ist.

5. Leistungsbaugruppe nach Anspruch 1, wobei
die mindestens eine erste Durchkontaktierung (48a) in einem ersten Abschnitt (420 a/b) der isolierenden Folie (42) benachbart der ersten Hauptfläche (30 a/b) des Leistungshalbleiterbauelements (3 a/b) angeordnet ist.

6. Leistungsbaugruppe nach Anspruch 5, wobei
der erste Abschnitt (420 a/b) der isolierenden Folie (42) in seiner horizontalen Ausdehnung das jeweilige Leistungshalbleiterbauelement (3 a/b) allseitig überlappt.

7. Leistungsbaugruppe nach Anspruch 6, wobei
der erste Abschnitt (420 a/b) der isolierenden Folie (42) bis an den, dem zugeordneten Leistungshalbleiterbauelement (3 a/b) zugewandten, Rand (454, 456) der Kontaktfläche (444, 446) der zweiten Leiterbahn (44) reicht.

8. Leistungsbaugruppe nach Anspruch 1, wobei
die jeweilige erste Teilfolie (400 a/b, 402) einer erste leitende Folie (40) horizontal bis maximal an den Rand des zugeordneten Leistungshalbleiterbauelements ausgedehnt ist und somit das Leistungshalbleiterbauelement (3 a/b) horizontal nicht überlappt.

9. Leistungsbaugruppe nach Anspruch 1, wobei
die leitenden Folien (40, 44) eine Dicke zwischen 50µm und 500µm und die mindestens eine isolierende Folie (42) eine Dicke zwischen 10µm und 100µm aufweisen.

10. Leistungsbaugruppe nach Anspruch 9, wobei
die erste elektrisch leitende Folie (40) dünner ausgebildet ist als die zweite elektrisch leitende Folie (44).
